(19) **Europäisches Patentamt**

**European Patent Office**

**Office européen des brevets**

(11) **EP 0 904 550 B1**

(12) **EUROPÄISCHE PATENTSCHRIFT**

(45) Veröffentlichungstag und Bekanntmachung des Hinweises auf die Patenterteilung:
**22.08.2001  Patentblatt 2001/34**

(21) Anmeldenummer: **97930301.3**

(22) Anmeldetag: **03.06.1997**

(51) Int Cl.$^7$: **G01R 33/032**

(86) Internationale Anmeldenummer:
**PCT/DE97/01111**

(87) Internationale Veröffentlichungsnummer:
**WO 97/48987 (24.12.1997 Gazette 1997/55)**

(54) **VERFAHREN ZUR TEMPERATURKALIBRIERUNG EINER OPTISCHEN MAGNETFELDMESSANORDNUNG UND MIT DIESEM VERFAHREN KALIBRIERTE MESSANORDNUNG**

TEMPERATURE CALIBRATION PROCESS FOR AN OPTICAL MAGNETIC FIELD MEASUREMENT DEVICE AND MEASUREMENT DEVICE CALIBRATED BY THIS PROCESS

PROCEDE D'ETALONNAGE THERMIQUE D'UN DISPOSITIF OPTIQUE DE MESURE DES CHAMPS MAGNETIQUES ET DISPOSITIF DE MESURE ETALONNE SELON CE PROCEDE

(84) Benannte Vertragsstaaten:
**CH DE FR GB IT LI**

(30) Priorität: **14.06.1996  DE 19623810**

(43) Veröffentlichungstag der Anmeldung:
**31.03.1999   Patentblatt 1999/13**

(73) Patentinhaber: **SIEMENS AKTIENGESELLSCHAFT**
**80333 München (DE)**

(72) Erfinder:
  • **BOSSELMANN, Thomas**
    **D-91054 Erlangen (DE)**
  • **MENKE, Peter**
    **D-91054 Erlangen (DE)**

(56) Entgegenhaltungen:
**DE-A- 4 432 146**          **US-A- 4 564 754**

• **MENKE P ET AL: "TEMPERATURE COMPENSATION IN MAGNETOOPTIC AC CURRENT SENSORS USING AN INTELLIGENT AC-DC SIGNAL EVALUATION" JOURNAL OF LIGHTWAVE TECHNOLOGY, Bd. 13, Nr. 7, 1.Juli 1995, Seiten 1362-1370, XP000597658**
• **XIAOJUN FANG ET AL: "A RECIPROCAL-COMPENSATED FIBER-OPTIC ELECTRIC CURRENT SENSOR" JOURNAL OF LIGHTWAVE TECHNOLOGY, Bd. 12, Nr. 10, Oktober 1994, Seiten 1882-1890, XP000469540 in der Anmeldung erwähnt**

**Beschreibung**

Die Erfindung betrifft ein Verfahren zur Temperaturkalibrierung einer optischen Meßanordnung zum Messen eines Magnetfeldes und eine optische Meßanordnung zum Messen eines Magnetfeldes.

Es sind optische Meßanordnungen und Meßverfahren zum Messen eines Magnetfeldes unter Ausnutzung des magnetooptischen Faraday-Effekts bekannt. Unter dem Faraday-Effekt versteht man die Drehung der Polarisationsebene von linear polarisiertem Licht in Abhängigkeit von einem Magnetfeld. Der Drehwinkel ist proportional zum Wegintegral über das Magnetfeld entlang des von dem Licht zurückgelegten Weges mit der sogenannten Verdet-Konstanten als Proportionalitätskonstante. Die Verdet-Konstante ist im allgemeinen material-, temperatur- und wellenlängenabhängig. Zum Messen des Magnetfeldes wird eine Faraday-Sensoreinrichtung aus einem optisch transparenten Material wie beispielsweise Glas in dem Magnetfeld angeordnet. Das Magnetfeld bewirkt eine Drehung der Polarisationsebene von durch die Faraday-Sensoreinrichtung gesendetem linear polarisiertem Licht um einen Drehwinkel, die für ein Meßsignal ausgewertet werden kann. Eine bekannte Anwendung finden solche magnetooptischen Meßverfahren und Meßanordnungen beim Messen elektrischer Ströme. Die Faraday-Sensoreinrichtung wird dazu in der Nähe eines Stromleiters angeordnet und erfaßt das von einem Strom in dem Stromleiter erzeugte Magnetfeld. Im allgemeinen umgibt die Faraday-Sensoreinrichtung den Stromleiter, so daß das Meßlicht den Stromleiter in einem geschlossenen Weg umläuft. Der Betrag des Drehwinkels ist in diesem Fall direkt proportional zur Amplitude des zu messenden Stromes. Die Faraday-Sensoreinrichtung kann als massiver Glasring um den Stromleiter ausgebildet sein oder auch den Stromleiter in Form einer Meßwicklung aus einer lichtleitenden Faser (Faserspule) mit wenigstens einer Windung umgeben.

Vorteile magnetooptischer Meßanordnungen und Meßverfahren gegenüber herkömmlichen induktiven Stromwandlern sind die Potentialtrennung und die Unempfindlichkeit gegenüber elektromagnetischen Störungen. Probleme bereiten jedoch Temperatureinflüsse und Einflüsse von mechanischen Biegungen und Vibrationen in der Sensoreinrichtung und den optischen Übertragungsstrecken, insbesondere Lichtleitfasern, zum Übertragen des Meßlichts.

Aus *Journal of Lightwave Technology*, *Vol.12. No. 10, October 1994, Seiten 1882 bis 1890* ist ein magnetooptisches Meßsystem bekannt, bei dem zwei Lichtsignale eine optische Reihenschaltung aus einer ersten Lichtleitfaser, einem ersten Polarisator, einer Faraday-Sensoreinrichtung, einem zweiten Polarisator und einer zweiten Lichtleitfaser in zueinander entgegengesetztem Umlaufsinn durchlaufen. Beide Lichtsignale werden nach Durchlaufen der optischen Reihenschaltung von entsprechenden photoelektrischen Wandlern in jeweils ein elektrisches Intensitätssignal umgewandelt. Als Faraday-Sensoreinrichtung ist eine Faserspule aus einer Single-Mode-Faser mit einer niedrigen Doppelbrechung vorgesehen. Die Polarisationsachsen der beiden Polarisatoren schließen einen von 0° verschiedenen Polarisatorwinkel miteinander ein, der vorzugsweise 45° beträgt. Licht einer Lichtquelle wird in zwei Lichtsignale aufgeteilt, und diese beiden Lichtsignale werden jeweils über einen optischen Koppler und eine zugeordnete Übertragungs-Lichtleitfaser an entgegengesetzten Enden in die Faraday-Faserspule eingekoppelt. Aus zwei elektrischen Intensitätssignalen I1 und I2, die den Lichtintensitäten der beiden Lichtsignale nach Durchlaufen der Reihenschaltung entsprechen, wird ein intensitätsnormiertes Meßsignal abgeleitet, das dem Quotienten (I1-I2)/(I1+I2) aus der Differenz und der Summe der beiden Intensitätssignale entspricht. Damit können Intensitätsverlusten in dem gemeinsamen Lichtweg für die beiden gegenläufigen Lichtsignale und insbesondere vibrationsbedingte Dämpfungen in den beiden Lichtleitfasern im wesentlichen kompensiert werden. Es wird als Sensoreinrichtung eine temperaturunempfindliche Faserspule verwendet. Die Fertigung solcher Faserspulen ist jedoch problematisch.

Aus *US 5,008,611* ist ein magnetooptisches Meßsystem bekannt, bei dem ein Meßlichtsignal eine Reihenschaltung aus einem ersten Polarisator, einem Faraday-Element und einem zweiten Polarisator (Analysator) durchläuft. Zur Minimierung der Temperatureinflüsse durch die Temperaturabhängigkeit der linearen Doppelbrechung im Faraday-Element wird der Winkel zwischen der Transmissionsachse des ersten Polarisators und der Doppelbrechungseigenachse im Faraday-Element auf 10,3° und der Winkel zwischen der Transmissionsachse des zweiten Polarisators und der Doppelbrechungseigenachse im Faraday-Element auf 55,3° eingestellt. Diese Einstellung der Winkelwerte wurde empirisch ermittelt und setzt die Kenntnis der Doppelbrechungseigenachse (charakteristic direction) des Faraday-Elements voraus.

In dem *Journal of Lightwave Technology*, *Vol. 13, No. 7, July 1995, Seiten 1362 bis 1370,* wird ein magnetooptischer Wechselstromsensor offenbart, der auf dem Faraday-Effekt basiert und bei dem über eine besondere Auswertung eine Temperaturkompensation erreicht wird. Auch hier durchläuft ein Meßlichtsignal eine Reihenschaltung aus einer ersten optischen Übertragungsstrecke, einem ersten Polarisator, einer Faraday-Sensoreinrichtung, einem zweiten Polarisator und einer zweiten optischen Übertragungsstrecke. Nach einer opto-elektrischen Wandlung und einer Intensitätsnormierung wird in einer Auswerteeinheit unter Berücksichtigung eines Korrekturfaktors ein temperaturkompensiertes Meßsignal abgeleitet. Vorab werden sowohl die Winkelstellungen der beiden Polarisatoren als auch der in der Auswerteeinheit verwendete Korrekturfaktor ermittelt. Nach welchen Vorschriften diese Vorabermittlung erfolgt, wird in dem Aufsatz nicht näher beschrieben.

Der Erfindung liegt nun die Aufgabe zugrunde, ein Verfahren zum Kalibrieren einer optischen Meßanordnung zum Messen eines Magnetfeldes und eine kalibrierte Meßanordnung anzugeben, so daß Einflüsse von Temperaturänderungen praktisch eliminiert sind.

Diese Aufgabe wird gemäß der Erfindung gelöst mit den Merkmalen des Anspruchs 1 oder des Anspruchs 2 bzw. des Anspruchs 6.

Die zu kalibrierende Meßanordnung umfaßt eine optische Reihenschaltung aus einer ersten optischen Übertragungsstrecke, einem ersten Polarisator, einer Faraday-Sensoreinrichtung, einem zweiten Polarisator und einer zweiten optischen Übertragungsstrecke. Die Polarisationsachse des ersten Polarisators steht unter einem ersten Po-larisatorwinkel $\theta$ gegen eine vorgegebene Referenzachse. Die Polarisationsachse des zweiten Polarisators schließt mit dieser Referenzachse einen zweiten Polarisatorwinkel $\eta$ ein. Bei dem Verfahren zur Temperaturkalibrierung der optischen Meßanordnung werden diese beiden Polarisatorwinkel $\theta$ und $\eta$ auf hinsichtlich der Temperaturunempfind-lichkeit der Meßanordnung optimale Werte eingestellt. Zunächst wird die Sensoreinrichtung in einem Kalibriermagnetfeld angeordnet. Durch die optische Reihenschaltung der Meßanordnung wird wenigstens ein Lichtsignal geschickt, und aus der Lichtintensität des wenigstens einen Lichtsignals nach Durchlaufen der Reihenschaltung wird ein Meßsignal für das Kalibriermagnetfeld abgeleitet. Nun werden nacheinander vier Kalibrierschritte durchgeführt:

In einem ersten Kalibrierschritt wird der erste Polarisatorwinkel $\theta$ auf einen Wert $\theta_1$ und der zweite Polarisatorwinkel $\eta$ auf einen Wert $\eta_1$ eingestellt, so daß im wesentlichen die Bedingung

$$\sin(2\theta_1 - 2\eta_1) = 1 \text{ oder } \sin(2\theta_1 - 2\eta_1) = -1$$

erfüllt ist, und es wird das sich einstellende Meßsignal als erstes Kalibriersignal $M_1$ über einem vorgegebenen, wenig-stens zwei Temperaturwerte umfassenden Temperaturbereich hinweg ermittelt. In einem zweiten Kalibrierschritt wird der erste Polarisatorwinkel $\theta$ auf einen Wert $\theta_2$ und der zweite Polarisatorwinkel $\eta$ auf einen Wert $\eta_2$ eingestellt, so daß im wesentlichen die Bedingungen

$$\sin(2\theta_2 - 2\eta_2) = 1 \text{ oder } \sin(2\theta_2 - 2\eta_2) = -1$$

und

$$\cos(2\theta_2 + 2\eta_2) = -\cos(2\theta_1 + 2\eta_1)$$

erfüllt sind, und es wird das sich einstellende Meßsignal als zweites Kalibriersignal $M_2$ über den vorgegebenen Tem-peraturbereich hinweg ermittelt.

In einem dritten Kalibrierschritt wird ein Korrekturfaktor K so ermittelt, daß eine von dem ersten Kalibriersignal $M_1$, dem zweiten Kalibriersignal $M_2$ und dem Korrekturfaktor K abhängige Kalibrierfunktion

$M_K = (2 \cdot M_1 \cdot M_2)/(M_1 + M_2 + K \cdot (M_1 - M_2))$ über den vorgegebenen Temperaturbereich im wesentlichen konstant ist.

Bei dem Verfahren nach Anspruch 1 werden nun in einem vierten Kalibrierschritt die Polarisatorwinkel $\theta$ und $\eta$ der beiden Polarisatoren so eingestellt, daß im wesentlichen die Beziehungen

$$\sin(2\theta - 2\eta) = 1 \text{ oder } \sin(2\theta - 2\eta) = -1$$

und

$$\cos(2\theta + 2\eta) = K \cdot \cos(2\theta_1 + 2\eta_1)$$

erfüllt sind.

Bei dem Verfahren nach Anspruch 2 werden dagegen in einem vierten Kalibrierschritt die Polarisatorwinkel $\theta$ und $\eta$ der beiden Polarisatoren so eingestellt, daß das sich einstellende Meßsignal bei wenigstens einem Temperaturwert aus dem vorgegebenen Temperaturbereich im wesentlichen gleich der Kalibrierfunktion $M_K$ ist.

Sowohl beim Verfahren nach Anspruch 1 als auch beim Verfahren nach Anspruch 2 erhält man Polarisator-winkel $\theta$ und $\eta$, mit denen die Meßanordnung auf eine minimale Temperaturdrift kalibriert ist.

Das Kalibrierverfahren funktioniert auch dann, wenn die Sensoreinrichtung der Meßanordnung eine inhomogene lineare Doppelbrechung aufweist, und selbst dann, wenn eine Eigenachse der linearen Doppelbrechung in der Sensoreinrichtung nicht ermittelt werden kann.

Vorteilhafte Ausgestaltungen und Weiterbildungen des Verfahrens und der Meßanordnung gemäß der Erfindung ergeben sich aus den von den Ansprüchen 1, 2 oder 6 jeweils abhängigen Ansprüchen.

In einer vorteilhaften Ausführungsform wird die optische Reihenschaltung der Meßanordnung von zwei Lichtsignalen in zueinander entgegengesetzten Durchlaufrichtungen durchlaufen.

Als Meßsignal wird dann ein Quotientensignal zweier linearer Funktionen der Lichtintensitäten der beiden Lichtsignale jeweils nach deren Durchlaufen der optischen Reihenschaltung und vorzugsweise ein zum Quotienten aus einer Differenz und der Summe der beiden Lichtintensitäten proportionales Signal oder ein Effektivwert dieses Signals herangezogen.

In einer anderen Ausführungsform wird die optische Reihenschaltung von nur einem Lichtsignal durchlaufen. Das Kalibriermagnetfeld ist dann ein im wesentlichen konstantes Wechselfeld, d.h. ein magnetisches Wechselfeld mit einem im wesentlichen konstanten Frequenzspektrum oberhalb einer vorgegebenen Frequenz. Als Meßsignal wird ein Signal herangezogen, das proportional zu dem Quotienten aus einem Wechselanteil der Lichtintensität des Lichtsignals nach Durchlaufen der Reihenschaltung und einem Gleichanteil dieser Lichtintensität ist. Der Wechselanteil enthält im wesentlichen das gesamte Frequenzspektrum des Kalibriermagnetfeldes, während der Gleichanteil keine Frequenzen aus dem Frequenzspektrum des Kalibriermagnetfeldes aufweist, also nicht vom Kalibriermagnetfeld abhängt. Dieses Meßsignal ist intensitätsnormiert.

Zur weiteren Erläuterung der Erfindung wird auf die Zeichnung Bezug genommen, in deren

FIG 1            eine zu kalibrierende Meßanordnung zum Messen eines Magnetfeldes mit einer Faraday-Sensoreinrichtung und zwei Polarisatoren,

FIG 2            eine zu kalibrierende Meßanordnung zum Messen eines Magnetfeldes über ein Lichtsignal,

FIG 3            eine Meßanordnung zum Messen eines elektrischen Stromes über zwei Lichtsignale und

FIG. 4 - FIG 6   Kalibrierschritte zum Einstellen optimaler Polarisationswinkel der Polarisatoren

jeweils schematisch dargestellt sind. Einander entsprechende Teile sind mit denselben Bezugszeichen versehen.

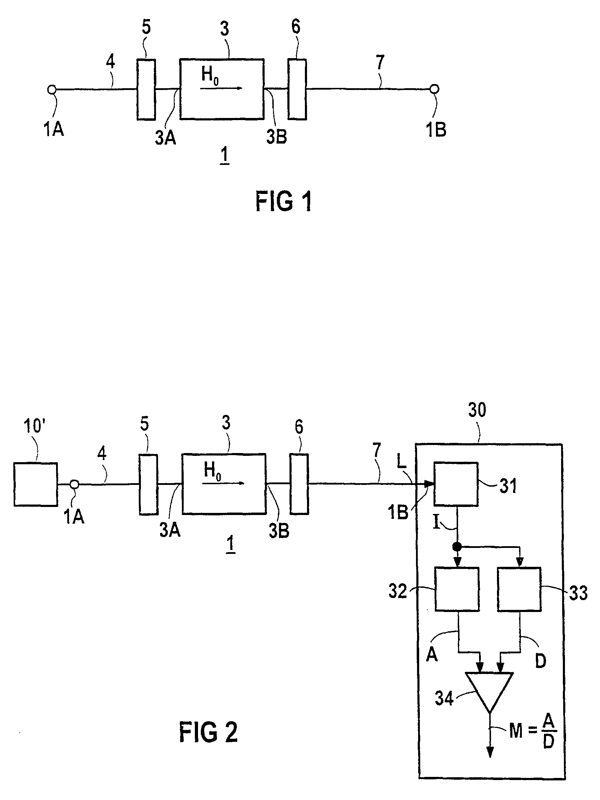

Die Meßanordnung gemäß FIG 1 enthält eine optische Reihenschaltung 1 aus einer ersten optischen Übertragungsstrecke 4, einem ersten Polarisator 5, einer Sensoreinrichtung 3, einem zweiten Polarisator 6 und einer zweiten optischen Übertragungsstrecke 7. Die Sensoreinrichtung 3 weist zwei optische Anschlüsse 3A und 3B derart auf, daß an einem Anschluß 3A oder 3B eingekoppeltes Licht die Sensoreinrichtung 3 durchläuft und am jeweils anderen Anschluß 3B bzw. 3A wieder ausgekoppelt wird. Der erste Anschluß 3A der Sensoreinrichtung 3 ist über den ersten Polarisator 5 mit einem Ende der ersten optischen Übertragungsstrecke 4 optisch gekoppelt. Der zweite Anschluß 3B der Sensoreinrichtung 3 ist über den zweiten Polarisator 6 mit einem Ende der zweiten optischen Übertragungsstrecke 7 optisch gekoppelt. Das vom ersten Polarisator 5 abgewandte Ende der ersten optischen Übertragungsstrecke 4 bildet einen ersten Anschluß 1A der Reihenschaltung 1. Das vom zweiten Polarisator 6 abgewandte Ende der zweiten optischen Übertragungsstrecke 7 bildet einen zweiten Anschluß 1B der Reihenschaltung 1. Koppelt man an einem Anschluß 1A oder 1B Meßlicht ein, so wird das Meßlicht durch die Reihenschaltung 1 transmittiert und an dem jeweils anderen Anschluß 1B bzw. 1A wieder aus der Reihenschaltung 1 ausgekoppelt.

Die Sensoreinrichtung 3 besteht aus wenigstens einem den magnetooptischen Faraday-Effekt zeigenden Material und kann in an sich bekannter Weise mit einem oder mehreren massiven Körpern, vorzugsweise aus Glas, oder auch mit mindestens einer optischen Faser ausgebildet sein.

Ein Problem bei der Messung eines Magnetfeldes mit einer Meßanordnung gemäß FIG 1 stellen nun Temperatureinflüsse in der Sensoreinrichtung 3 dar. Diese Temperatureinflüsse induzieren eine lineare Doppelbrechung $\delta$ als Funktion $\delta(T)$ der Temperatur T in der Sensoreinrichtung 3, die die Messung des Magnetfeldes verfälschen kann. Ferner können Temperaturänderungen auch die Verdet-Konstante und damit die Meßempfindlichkeit verändern.

Um diese Temperatureinflüsse möglichst gering zu halten, wird die Meßanordnung mit einem Kalibrierverfahren temperaturkalibriert. Dazu wird die Sensoreinrichtung 3 in einem Kalibriermagnetfeld $H_0$ angeordnet.

In einer ersten, in FIG 2 dargestellten Ausführungsform des Kalibrierverfahrens wird nur ein einziges Lichtsignal L durch die optische Reihenschaltung 1 gesendet. Dazu wird beispielsweise der Anschluß 1A der Reihenschaltung 1 mit einer Lichtquelle optisch gekoppelt. Als Kalibriermagnetfeld $H_0$ wird ein magnetisches Wechselfeld mit einem im wesentlichen konstanten Frequenzspektrum oberhalb einer vorgegebenen Frequenz verwendet. Nach Durchlaufen der Reihenschaltung 1 wird von Auswertemitteln 30 aus dem Lichtsignal L ein Meßsignal M abgeleitet, das proportional zu dem Quotienten aus einem Wechselanteil der Lichtintensität des Lichtsignals nach Durchlaufen der Reihenschaltung und einem Gleichanteil dieser Lichtintensität ist. Der Wechselanteil enthält im wesentlichen das gesamte Frequenzspektrum des Kalibriermagnetfeldes, während der Gleichanteil keine Frequenzen aus dem Frequenzspektrum des Kalibriermagnetfeldes aufweist, also nicht vom Kalibriermagnetfeld abhängt. Dazu wird mit einem dem Anschluß 1B der Reihenschaltung 1 zugeordneten Photodetektor 31 das Lichtsignal L in ein elektrisches Intensitätssignal I als Maß für die Lichtintensität des Lichtsignals L umgewandelt. Von diesem elektrischen Intensitätssignal I wird mit einem Hochpaßfilter 32 ein Wechselsignalanteil A als Maß für den Wechselanteil der Lichtintensität und mit einem Tiefpaßfilter 33 ein Gleichsignalanteil D als Maß für den Gleichanteil der Lichtintensität gebildet. Ein Dividierer 34 bildet den Quotienten A/D aus Wechselsignalanteil A und Gleichsignalanteil D des Intensitätssignals I als Meßsignal M. Das so gebildete Meßsignal M ist intensitätsnormiert, jedoch noch temperaturabhängig.

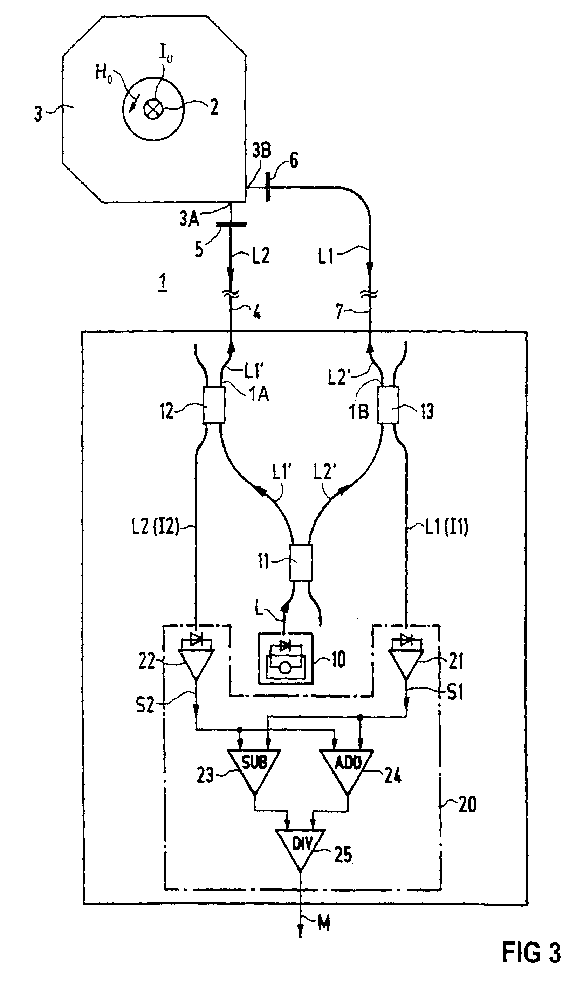

In einer anderen Ausführungsform des Kalibrierverfahrens werden zwei Lichtsignale in entgegengesetzten Richtungen durch die Reihenschaltung 1 geschickt und danach einer Signalauswertung unterzogen. Als Meßsignal wird dann ein Quotientensignal zweier linearer Funktionen der Lichtintensitäten der beiden Lichtsignale jeweils nach deren Durchlaufen der optischen Reihenschaltung und vorzugsweise ein zum Quotienten aus einer Differenz und der Summe der beiden Lichtintensitäten proportionales Signal oder ein Effektivwert dieses Signals bestimmt. Auch dieses Meßsignal ist intensitätsnormiert, jedoch noch temperaturabhängig. Als Kalibriermagnetfeld $H_0$ wird in dieser Ausführungsform vorzugsweise ein zeitlich konstantes Magnetfeld verwendet. Eine vorteilhafte Ausführungsform einer Meßanordnung für ein solches Kalibrierverfahren mit zwei Lichtsignalen ist in FIG 3 dargestellt.

Die Meßanordnung gemäß FIG 3 enthält Mittel zum Senden von zwei gegensinnig die Reihenschaltung durchlaufenden Lichtsignalen L1' und L2' durch die Reihenschaltung 1 und Auswertemittel 20 zum Auswerten der Lichtsignale L1 und L2 nach Durchlaufen der Reihenschaltung 1. Die Mittel zum Senden der beiden Lichtsignale L1' und L2' umfassen eine Lichtquelle 10 und drei optische Koppler 11, 12 und 13. Das von der Sensoreinrichtung 3 abgewandte andere Ende der ersten Übertragungsstrecke 4 (Anschluß 1A der Reihenschaltung 1) ist über den optischen Koppler 12 sowohl mit dem weiteren optischen Koppler 11 als auch mit den Auswertemitteln 20 optisch verbunden. Das von der Sensoreinrichtung 3 abgewandte andere Ende der zweiten Übertragungsstrecke 7 (Anschluß 1B der Reihenschaltung 1) ist über den optischen Koppler 13 ebenfalls sowohl mit dem optischen Koppler 11 als auch mit den Auswertemitteln 20 optisch verbunden. Der optische Koppler 11 ist mit der Lichtquelle 10 optisch verbunden und teilt das Licht L der Lichtquelle 10 in zwei Lichtsignale L1' und L2' auf, die den Kopplern 12 bzw. 13 zugeführt werden und dann in die erste bzw. zweite Übertragungsstrecke 4 bzw. 7 eingekoppelt werden. Beide Lichtsignale L1' und L2' durchlaufen die optische Reihenschaltung 1 aus erster Übertragungsstrecke 4, erstem Polarisator 5, Sensoreinrichtung 3, zweitem Polarisator 6 und zweiter Übertragungsstrecke 7 in zueinander entgegengesetzten Durchlaufrichtungen und werden als nun mit L1 bzw. L2 bezeichnete Lichtsignale wieder aus der Reihenschaltung 1 ausgekoppelt.

Die Koppler 11, 12 und 13 können wenigstens teilweise auch durch optische Strahlteiler ersetzt werden. Außerdem können auch anstelle des Kopplers 11 und der einen Lichtquelle 10 auch zwei Lichtquellen vorgesehen sein, die jeweils ein Lichtsignal L1' bzw. L2' senden. Die Mittel zum Senden von zwei gegensinnig die Reihenschaltung durchlaufenden Lichtsignalen L1 und L2 durch die Reihenschaltung können ferner auch mit zwei abwechselnd als Sender und Empfänger betriebenen photoelektrischen Wandlern gebildet sein, die dann zugleich zum Umwandeln der Lichtsignale L1 und L2 nach Durchlaufen der Reihenschaltung in elektrische Intensitätssignale vorgesehen sind.

Das erste Lichtsignal L1' wird nach Durchlaufen der ersten Übertragungsstrecke 4 von dem ersten Polarisator 5 linear polarisiert und als nunmehr linear polarisiertes Lichtsignal L1' am Anschluß 3A in die Sensoreinrichtung 3 eingespeist. Beim Durchlaufen der Sensoreinrichtung 3 wird die Polarisationsebene des linear polarisierten ersten Lichtsignals L1' um einen vom Kalibriermagnetfeld $H_0$ abhängigen Faraday-Meßwinkel gedreht. Das in seiner Polarisationsebene um den Meßwinkel gedrehte erste Lichtsignal L1' wird nun dem zweiten Polarisator 6 zugeführt. Der zweite Polarisator 6 läßt nur den auf seine Polarisationsachse projizierten Anteil des ankommenden ersten Lichtsignals L1' durch und hat somit für das erste Lichtsignal L1' die Funktion eines Polarisationsanalysators. Der vom zweiten Polarisator 6 transmittierte Anteil des ersten Lichtsignals L1' ist nun mit L1 bezeichnet und wird über die zweite Übertragungsstrecke 7 und den Koppler 13 zu den Auswertemitteln 20 übertragen.

Das zweite Lichtsignal L2' passiert zunächst die zweite Übertragungsstrecke 7 und wird sodann von dem zweiten Polarisator 6 linear polarisiert. Das linear polarisierte zweite Lichtsignal L2' wird nun am Anschluß 3B in die Sensoreinrichtung 3 eingekoppelt. Beim Durchlaufen der Sensoreinrichtung 3 wird die Polarisationsebene des linear polarisierten zweiten Lichtsignals L2' um einen vom Kalibriermagnetfeld $H_0$ abhängigen Faraday-Meßwinkelgedreht, der wegen der nicht-reziproken Eigenschaft des Faraday-Effekts das entgegengesetzte Vorzeichen und den gleichen Betrag wie beim ersten Lichtsignal L1' hat. Das in seiner Polarisationsebene um den Meßwinkel gedrehte zweite Lichtsignal L2' wird nun dem ersten Polarisator 5 zugeführt. Der erste Polarisator 5 läßt nur den auf seine Polarisationsachse projizierten Anteil des ankommenden zweiten Lichtsignals L2' durch und wirkt somit für das zweite Lichtsignal L2' als Polarisationsanalysator. Der vom ersten Polarisator 5 transmittierte Anteil des zweiten Lichtsignals L2' ist nun mit L2 bezeichnet und wird über die erste Übertragungsstrecke 4 und den Koppler 12 zu den Auswertemitteln 20 übertragen.

Die Lichtintensitäten I1' und I2' der beiden Lichtsignale L1' und L2' vor dem Einkoppeln in die Reihenschaltung werden im allgemeinen in einem fest vorgegebenen Verhältnis zueinander eingestellt. Vorzugsweise sind beide Lichtintensitäten gleich, also I1' = I2'. In den dargestellten Ausführungsformen teilt der Koppler 11 das Licht L der Lichtquelle 10 dann in zwei gleiche Teile mit einem Kopplungsverhältnis 50%:50%.

Beim Durchlaufen der beiden Übertragungsstrecken 4 und 7 erfahren beide Lichtsignale L1' bzw. L1 und L2' bzw. L2 jeweils die gleichen Intensitätsänderungen, die insbesondere durch Dämpfungsverluste infolge von mechanischen Vibrationen verursacht werden können. Diese Intensitätsänderungen gehen im wesentlichen in Form von Dämpfungsfaktoren in die Lichtintensitäten I1 und I2 ein. Der reelle, im allgemeinen zeitabhängige Dämpfungsfaktor einer optischen Übertragungsstrecke ist definiert als das Verhältnis der Lichtintensität von an einem Ende der Übertragungsstrecke ankommendem Licht zu der Eingangslichtintensität des Lichts beim Einkoppeln in das andere Ende der Übertragungsstrecke. Die Dämpfungsfaktoren der Übertragungsstrecken 4 und 7 werden nun eliminiert, indem die Auswertemittel 20 im allgemeinen als Meßsignal M für das Kalibriermagnetfeld $H_0$ ein Quotientensignal der Gestalt

$$M = (a \cdot I1 + b \cdot I2 + c)/(d \cdot I1 + e \cdot I2 + f) \tag{1}$$

aus zwei linearen Funktionen a·I1+b·I2+c und d·I1+e·I2+f der beiden Lichtintensitäten I1 und I2 mit den reellen Koeffizienten a, b, c, d, e und f ableiten. Dabei sind wenigstens entweder die Koeffizienten a und e oder die Koeffizienten b und d von Null verschieden.

Dieses Meßsignal M ist von insbesondere von Vibrationen verursachten Intensitätsänderungen in den Übertragungsstrecken 4 bzw. 7 praktisch unabhängig. Somit können in allen Ausführungsformen auch einfache, vergleichsweise preiswerte Telekommunikationslichtfasern (Multimode-Fasern) als Übertragungsstrecken 4 und 7 verwendet werden, da deren relativ hohe Dämpfungen und Vibrationsempfindlichkeiten im Meßsignal M kompensiert sind. Als Übertragungsstrecken 4 und 7 können aber auch andere Lichtwellenleiter oder Freistrahlanordnungen verwendet werden.

Die Koeffizienten a, b, c, d, e und f der linearen Funktionen im Zähler und Nenner von Gleichung (1) können insbesondere unterschiedlichen Eingangsintensitäten der beiden Lichtsignale beim Einkoppeln in die Reihenschaltung angepaßt werden. Die Koeffizienten d, e und f der linearen Funktion d·I1+e·I2+f im Nenner des Quotienten gemäß Gleichung (1) werden vorzugsweise so eingestellt, daß die lineare Funktion d·I1+e·I2+f praktisch konstant und damit unabhängig vom Magnetfeld $H_0$ ist.

Insbesondere bei wenigstens annähernd gleichen Eingangsintensitäten I1' und I2' beider Lichtsignale L1' und L2' kann in der in FIG 3 dargestellten vorteilhaften Ausführungsform als Meßsignal M auch der Quotient

$$M = (I1 - I2)/(I1 + I2)$$

aus einer Differenz I1-I2 (oder I2-I1) und der Summe I1+I2 beider Lichtintensitäten I1 und I2 nach Durchlaufen der Reihenschaltung verwendet werden. In der dargestellten Ausführungsform umfassen die Auswertemittel 20 zum Ableiten des Meßsignals M zwei photoelektrische Wandler 21 und 22, einen Subtrahierer 23, einen Addierer 24 und einen Dividierer 25. Der erste Wandler 21 ist optisch mit dem Koppler 13 verbunden und wandelt das erste Lichtsignal L1 nach dessen Durchlaufen der Reihenschaltung in ein erstes elektrisches Intensitätssignal S1 um, dessen Signalstärke der Lichtintensität I1 des ersten Lichtsignals L1 entspricht. Der zweite Wandler 22 ist mit dem Koppler 12 optisch verbunden und konvertiert das zweite Lichtsignal L2 nach dessen Durchlauf durch die Reihenschaltung in ein zweites elektrisches Intensitätssignal S2 als Maß für die Lichtintensität I2 des zweiten Lichtsignals L2. Beide elektrischen Intensitätssignale S1 und S2 werden jeweils einem Eingang des Subtrahierers 23 und des Addierers 24 zugeführt. Das Differenzsignal S1-S2 (oder S2-S1) am Ausgang des Subtrahierers 23 und das Summensignal S1+S2 am Ausgang des Addierers 24 werden jeweils einem Eingang des Dividierers 25 zugeführt. Das Ausgangssignal des Dividierers (S1-S2)/(S1+S2) wird als Meßsignal M herangezogen und auf einen Ausgang der Auswertemittel 20 geschaltet. Diese Ausführungsform hat den Vorteil, daß analoge Komponenten, die in der Regel schneller arbeiten als digitale Komponenten, verwendet werden können.

In einer nicht dargestellten Ausführungsform können die beiden elektrischen Intensitätssignale aber auch zunächst mit Hilfe eines Analog/Digital-Wandlers digitalisiert werden und dann die digitalisierten Signale von einem Mikroprozessor oder einem digitalen Signalprozessor weiterverarbeitet werden.

Durch Anpassen der Koeffizienten a, b, c, d, e und f im allgemeinen Meßsignal $M = (a \cdot I1 + b \cdot I2 + c)/(d \cdot I1 + e \cdot I2 + f)$ können insbesondere auch unterschiedliche Empfindlichkeiten der beiden photoelektrischen Wandler 21 und 22 ausgeglichen werden.

Die zu kalibrierende Meßanordnung gemäß FIG 3 ist vorzugsweise zum Messen eines elektrischen Stromes I in wenigstens einem Stromleiter 2 vorgesehen. Die Sensoreinrichtung 3 erfaßt dann das von diesem Strom I induktiv erzeugte Magnetfeld. Vorzugsweise umgibt die Sensoreinrichtung 3 den Stromleiter 2, so daß beide Lichtsignale L1' und L2' den Strom I in einem praktisch geschlossenen Lichtpfad umlaufen. Der Meßwinkel ist in diesem Fall direkt proportional zum elektrischen Strom I. Die Sensoreinrichtung 3 kann als massiver Glasring mit die Lichtsignale L1' und L2' umlenkenden inneren Reflexionsflächen oder auf andere bekannte Art und Weise ausgebildet sein. Das konstante Kalibriermagnetfeld $H_0$ kann durch Einstellen eines konstanten Stromes I in dem Stromleiter 2 eingestellt werden.

Die Temperaturabhängigkeit des Meßsignals M wird nun durch das im folgenden beschriebene Kalibrierverfahren zur Temperaturkompensation im wesentlichen beseitigt. Die Kalibrierung geschieht durch die optimale Einstellung der Polarisatorwinkel der beiden Polarisatoren 5 und 6.

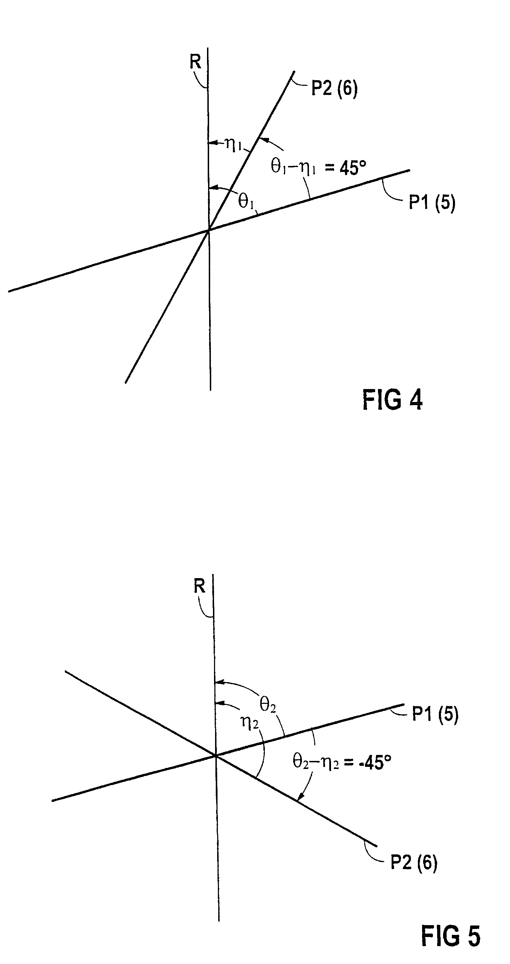

Die FIG 4 bis 6 veranschaulichen drei mögliche Kalibrierschritte zum Einstellen dieser optimalen Polarisatorwinkel der Polarisatoren 5 und 6. In den FIG 4 bis 6 sind eine Polarisationsachse (Transmissionsachse, charakteristische Achse, Eigenachse) des ersten Polarisators 5 mit P1 und eine Polarisationsachse des zweiten Polarisators 6 mit P2 bezeichnet. Die Polarisationsachsen P1 und P2 liegen in einer Ebene, die senkrecht zur Lichtausbreitungsrichtung des durch die Polarisatoren 5 und 6 hindurchtretenden Lichts gerichtet ist. Eine ebenfalls in dieser Ebene liegende, beliebig vorgebbare Referenzachse ist mit R bezeichnet. Die Polarisationsachse P1 des ersten Polarisators 5 schließt einen ersten Polarisatorwinkel $\theta$ mit der vorgegebenen Referenzachse R ein, während die Polarisationsachse P2 des zweiten Polarisators 6 unter einem zweiten Polarisatorwinkel $\eta$ zur Referenzachse R gerichtet ist.

In einem ersten Kalibrierschritt werden die Polarisatorwinkel $\theta$ und $\eta$ der beiden Polarisatoren 5 bzw. 6 so eingestellt, daß eine maximale Kleinsignalempfindlichkeit erreicht wird. Dazu wird der erste Polarisatorwinkel $\theta$ auf einen ersten Kalibrierwert $\theta_1$ und der zweite Polarisatorwinkel $\eta$ auf einen ersten Kalibrierwert $\eta_1$ im wesentlichen gemäß der Bedingung

$$\sin(2\theta_1 - 2\eta_1) = 1 \qquad (1a)$$

oder

$$\sin(2\theta_1 - 2\eta_1) = -1 \qquad (1b)$$

eingestellt. Mit den so einjustierten Polarisatorwinkeln $\theta = \theta_1$ und $\eta = \eta_1$ wird das sich einstellende Meßsignal M als erstes Kalibriersignal $M_1$ über einen vorgegebenen, wenigstens zwei Temperaturwerte umfassenden Temperaturbereich hinweg aufgenommen und gespeichert. Der Temperaturbereich wird gemäß den zu erwartenden Einsatztemperaturen der Meßanordnung gewählt. Jeweils eine der Bedingungen (1a) oder (1b) ist insbesondere erfüllt, wenn die Polarisationsachsen P1 und P2 einen Winkel von $\pm 45°$ ($\pm \pi/4$) miteinander einschließen.

FIG 4 zeigt ein Ausführungsbeispiel, bei dem die Polarisatorwinkel $\theta$ und $\eta$ auf Kalibrierwerte $\theta_1$ bzw. $\eta_1$ eingestellt sind, die die Bedingung (1a) erfüllen. Die Polarisationsachse P2 des zweiten Polarisators 6 ist gegen die Polarisationsachse P1 des ersten Polarisators 5 um den Winkel $\theta_1 - \eta_1 = +45°$ geneigt. Positive Winkel entsprechen dabei und im folgenden dem mathematisch positiven Umlaufsinn (Gegenuhrzeigersinn).

In einem zweiten Kalibrierschritt wird der erste Polarisatorwinkel $\theta$ auf einen zweiten Kalibrierwert $\theta_2$ und der zweite Polarisatorwinkel $\eta$ auf einen zweiten Kalibrierwert $\eta_2$ eingestellt, so daß im wesentlichen die Bedingung

$$\sin(2\theta_2 - 2\eta_2) = 1 \qquad (2a)$$

oder

$$\sin(2\theta_2 - 2\eta_2) = -1 \qquad (2b)$$

einerseits und zugleich die Bedingung

$$\cos(2\theta_2 + 2\eta_2) = -\cos(2\theta_1 + 2\eta_1) \qquad (3)$$

andererseits erfüllt sind. Mit den derart eingestellten Polarisatorwinkeln $\theta = \theta_2$ und $\eta = \eta_2$ wird das sich einstellende Meßsignal M als zweites Kalibriersignal $M_2$ über den vorgegebenen Temperaturbereich hinweg ermittelt und ebenfalls gespeichert. Um die Polarisatorwinkel $\theta$ und $\eta$ auf ihre zweiten Kalibrierwerte $\theta_2$ bzw. $\eta_2$ einzustellen, kann man beispielsweise gegenüber den ersten Kalibrierwerten $\theta_1$ bzw. $\eta_1$ die Polarisationsachse P1 oder P2 eines der beiden Polarisatoren 5 bzw. 6 um 90° weiter drehen oder auch beide Polarsiationsachsen P1 und P2 jeweils um 45° weiter drehen.

FIG 5 zeigt eine besonders einfach zu justierende Ausführungsform des zweiten Kalibrierschritts. Die Polarisationsachse P1 des ersten Polarisators 5 bleibt im Vergleich zu der Einstellung in FIG 4 unverändert, d.h. $\theta_1 = \theta_2$, und es wird nur der zweite Polarisator 6 um -90° gegenüber der Referenzachse R gedreht, d.h. $\eta_2 = \eta_1 + 90°$. Der zwischen den beiden Polarisationsachsen P1 und P2 eingeschlossene Winkel ist dann $\theta_2 - \eta_2 = -45°$.

Die aus dem ersten Kalibrierschritt und dem zweiten Kalibrierschritt erhaltenen Kalibriersignale $M_1$ und $M_2$ sind Funktionen $M_1(T)$ bzw. $M_2(T)$ der Temperatur T über den vorgegebenen Temperaturbereich und lassen sich in guter Näherung wie folgt analytisch beschreiben:

$$M_1(T) = \frac{f_1(T)}{1 + \cos(2\theta_1 + 2\eta_1)f_2(T)} \tag{4}$$

$$M_2(T) = \frac{-f_1(T)}{1 + \cos(2\theta_2 + 2\eta_2)f_2(T)} = \frac{-f_1(T)}{1 - \cos(2\theta_1 + 2\eta_1)f_2(T)} \tag{5}$$

Durch Auflösen der beiden Gleichungen (4) und (5) nach $f_1(T)$ und nach $\cos(2\theta_1 + 2\eta_1)\,f_2(T)$ gelangt man unter Einfügung eines reellen Korrekturfaktors K zu der Gleichung für die Kalibrierfunktion

$$M_K(T) = \frac{2M_1M_2}{M_1 + M_2 + K(M_1 - M_2)} \tag{6}$$

Der Korrekturfaktor K wird in einem dritten Kalibrierschritt vorzugsweise durch ein einfaches numerisches Verfahren mit Hilfe eines digitalen Signalprozessors oder eines Mikroprozessors so bestimmt, daß die Temperaturdrift der zugehörigen Kalibrierfunktion $M_K(T)$ minimal wird. Das bedeutet, daß die von dem ersten Kalibriersignal $M_1$, dem zweiten Kalibriersignal $M_2$ und dem Korrekturfaktor K abhängige Kalibrierfunktion $M_K = (2 \cdot M_1 \cdot M_2)/(M_1 + M_2 + K \cdot (M_1 - M_2))$ über den vorgegebenen Temperaturbereich im wesentlichen konstant ist.

Wenn der vorgegebene Temperaturbereich (Eichbereich) nur zwei Temperaturwerte $T_a$ und $T_b$ umfaßt, wird dazu einfach mit Hilfe der entsprechenden Kalibriersignalwerte $M_1(T_a)$ und $M_2(T_a)$ sowie $M_1(T_b)$ und $M_2(T_b)$ die Gleichung

$$M_K(T_a) = M_K(T_b) \tag{7}$$

nach dem Korrekturfaktor K aufgelöst.

Umfaßt der vorgegebene Temperaturbereich dagegen mehr als zwei Temperaturmeßpunkte, so kann man in einem Graphen $y = f_1(T) = 2M_1M_2/(M_2-M_1)$ gegen $x = \cos(2\theta+2\eta)f_2(T) = (M_1+M_2)/(M_2-M_1)$ auftragen. Diesen Graphen fittet man linear mit der Funktion

$$y(x) = M_K (1 + K x) \tag{8}$$

mit den Fit-Parametern $M_K$ und K.

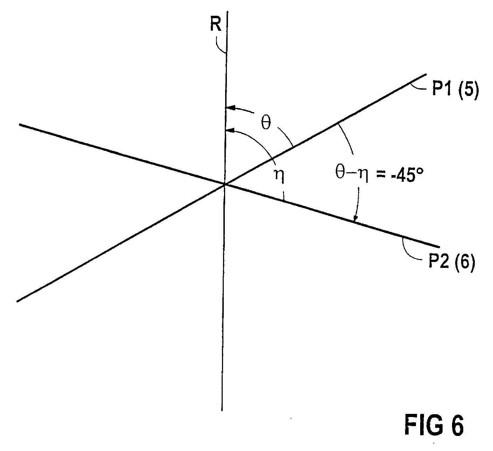

In einem vierten Kalibrierschritt werden nun die Polarisatorwinkel $\theta$ und $\eta$ der beiden Polarisatoren 5 bzw. 6 gemäß FIG 6 so eingestellt, daß das sich einstellende Meßsignal M eine minimale Temperaturdrift aufweist.

In einer ersten Ausführungsform dieses vierten Kalibrierschrittes werden die Polarisatorwinkel $\theta$ und $\eta$ der beiden Polarisatoren 5 bzw. 6 so eingestellt, daß im wesentlichen die Beziehungen

$$\sin(2\theta - 2\eta) = 1 \tag{9a}$$

oder

$$\sin(2\theta - 2\eta) = -1 \tag{9b}$$

und

$$\cos(2\theta + 2\eta) = K \cos(2\theta_1 + 2\eta_1) \tag{10}$$

erfüllt sind. Dazu können beispielsweise die Polarisationsachsen P1 und P2 gegenüber der Einstellung in FIG 5 gleichsinnig um denselben Winkel unter Beibehaltung des von den Polarisationsachsen P1 und P2 eingeschlossenen Winkels von -45° (Bedingung (9b)) solange gedreht werden, bis die Bedingung (10) erfüllt ist.

In einer zweiten Ausführungsform des vierten Kalibrierschrittes werden die Polarisatorwinkel $\theta$ und $\eta$ der beiden Polarisatoren 5 und 6 dagegen so eingestellt, daß das sich einstellende Meßsignal M bei wenigstens einem Temperaturwert $T_0$ aus dem vorgegebenen Temperaturbereich im wesentlichen gleich der Kalibrierfunktion $M_K$ ist, also gilt:

$$M(T_o) = M_K(T_o) \tag{11}.$$

Sowohl bei der ersten Ausführungsform gemäß den Gleichungen (9a), (9b) und (10) als auch bei der zweiten Ausführungsform gemäß Gleichung (11) des vierten Kalibrierschrittes sind die beiden Polarisatorwinkel $\theta$ und $\eta$ der beiden Polarisatoren 5 bzw. 6 optimal justiert für eine minimale Temperaturabhängigkeit des Meßsignals M im vorgegebenen Temperaturbereich.

Anstelle des Meßsignals M selbst kann für die Temperaturkalibrierung in allen Ausführungsformen auch der Effektivwert des Meßsignals M verwendet werden, wenn Wechselmagnetfelder gemessen werden sollen.

Ein grundsätzlicher Vorteil der Temperaturkompensation durch Einstellen der Polarisatorwinkel $\eta$ und $\theta$ ist die hohe Bandbreite beim Messen von Magnetfeldern **H** oder elektrische Strömen I. Das Frequenzspektrum der zu messenden Magnetfelder **H** oder elektrischen Ströme I wird durch die Maßnahmen zur Temperaturkompensation nämlich prinzipiell nicht beschränkt.

**Patentansprüche**

1.  Verfahren zur Temperaturkalibrierung einer optischen, zum Messen eines Magnetfeldes bestimmten Meßanordnung mit einer optischen Reihenschaltung (1) aus einer ersten optischen Übertragungsstrecke (4), einem ersten Polarisator (5) mit einer Polarisationsachse (P1), die einen ersten Polarisatorwinkel $\theta$ mit einer vorgegebenen Referenzachse (R) einschließt, einer Faraday-Sensoreinrichtung (3), einem zweiten Polarisator (6) mit einer Polarisationsachse (P2), die einen zweiten Polarisatorwinkel $\eta$ mit der Referenzachse (R) einschließt, und einer zweiten optischen Übertragungsstrecke (7), umfassend folgende Verfahrensschritte:

    a) die Faraday-Sensoreinrichtung (3) wird in einem Kalibriermagnetfeld (**H$_0$**) angeordnet;
    b) wenigstens ein Lichtsignal (L,L1,L2) durchläuft die optische Reihenschaltung (1);
    c) aus der Lichtintensität (I,I1,I2) des wenigstens einen Lichtsignals (L, L1, L2) nach Durchlaufen der Reihenschaltung (1) wird ein Meßsignal (M) für das Kalibriermagnetfeld ($H_o$) ermittelt,
    d) in einem ersten Kalibrierschritt wird der erste Polarisatorwinkel $\theta$ auf einen Wert $\theta_1$ und der zweite Polarisatorwinkel $\eta$ auf einen Wert $\eta_1$ eingestellt, so daß im wesentlichen die Bedingung

$$\sin(2\theta_1 - 2\eta_1) = 1 \text{ oder } \sin(2\theta_1 - 2\eta_1) = -1$$

    erfüllt ist, und es wird das sich einstellende Meßsignal als erstes Kalibriersignal $M_1$ über einen vorgegebenen, wenigstens zwei Temperaturwerte umfassenden Temperaturbereich hinweg ermittelt,
    e) in einem zweiten Kalibrierschritt wird der erste Polarisatorwinkel $\theta$ auf einen Wert $\theta_2$ und der zweite Polarisatorwinkel $\eta$ auf einen Wert $\eta_2$ eingestellt, so daß im wesentlichen die Bedingungen

$$\sin(2\theta_2 - 2\eta_2) = 1 \text{ oder } \sin(2\theta_2 - 2\eta_2) = -1$$

    einerseits und zugleich

$$\cos(2\theta_2 + 2\eta_2) = -\cos(2\theta_1 + 2\eta_1)$$

    andererseits erfüllt sind, und es wird das sich einstellende Meßsignal als zweites Kalibriersignal $M_2$ über den vorgegebenen Temperaturbereich hinweg ermittelt,

f) in einem dritten Kalibrierschritt wird ein Korrekturfaktor K so ermittelt, daß eine von dem ersten Kalibriersignal $M_1$, dem zweiten Kalibriersignal $M_2$ und dem Korrekturfaktor K abhängige Kalibrierfunktion $M_K = (2 \cdot M_1 \cdot M_2)/(M_1 + M_2 + K \cdot (M_1 - M_2))$ über den vorgegebenen Temperaturbereich im wesentlichen konstant ist;

g) in einem vierten Kalibrierschritt werden die Polarisatorwinkel $\theta$ und $\eta$ der beiden Polarisatoren (5,6) so eingestellt, daß im wesentlichen die Beziehungen

$$\sin(2\theta - 2\eta) = 1 \text{ oder } \sin(2\theta - 2\eta) = -1$$

einerseits und zugleich

$$\cos(2\theta + 2\eta) = K \cos(2\theta_1 + 2\eta_1)$$

andererseits erfüllt sind.

2. Verfahren zur Temperaturkalibrierung einer optischen, zum Messen eines Magnetfeldes bestimmten Meßanordnung mit einer optischen Reihenschaltung (1) aus einer ersten optischen Übertragungsstrecke (4), einem ersten Polarisator (5) mit einer Polarisationsachse (P1), die einen ersten Polarisatorwinkel $\theta$ mit einer vorgegebenen Referenzachse (R) einschließt, einer Faraday-Sensoreinrichtung (3), einem zweiten Polarisator (6) mit einer Polarisationsachse (P2), die einen zweiten Polarisatorwinkel $\eta$ mit der Referenzachse (R) einschließt, und einer zweiten optischen Übertragungsstrecke (7), umfassend folgende Verfahrensschritte:

a) die Faraday-Sensoreinrichtung (3) wird in einem Kalibriermagnetfeld (**$H_0$**) angeordnet;

b) wenigstens ein Lichtsignal (L,L1,L2) durchläuft die optische Reihenschaltung (1);

c) aus der Lichtintensität (I,I1,I2) des wenigstens einen Lichtsignals (L,L1,L2) nach Durchlaufen der Reihenschaltung (1) wird ein Meßsignal (M) für das Kalibriermagnetfeld (**$H_o$**) ermittelt,

d) in einem ersten Kalibrierschritt wird der erste Polarisatorwinkel $\theta$ auf einen Wert $\theta_1$ und der zweite Polarisatorwinkel $\eta$ auf einen Wert $\eta_1$ eingestellt, so daß im wesentlichen die Bedingung

$$\sin(2\theta_1 - 2\eta_1) = 1 \text{ oder } \sin(2\theta_1 - 2\eta_1) = -1$$

erfüllt ist, und es wird das sich einstellende Meßsignal als erstes Kalibriersignal $M_1$ über einen vorgegebenen, wenigstens zwei Temperaturwerte umfassenden Temperaturbereich hinweg ermittelt,

e) in einem zweiten Kalibrierschritt wird der erste Polarisatorwinkel $\theta$ auf einen Wert $\theta_2$ und der zweite Polarisatorwinkel $\eta$ auf einen Wert $\eta_2$ eingestellt, so daß im wesentlichen die Bedingungen

$$\sin(2\theta_2 - 2\eta_2) = 1 \text{ oder } \sin(2\theta_2 - 2\eta_2) = -1$$

einerseits und zugleich

$$\cos(2\theta_2 + 2\eta_2) = -\cos(2\theta_1 + 2\eta_1)$$

andererseits erfüllt sind, und es wird das sich einstellende Meßsignal als zweites Kalibriersignal $M_2$ über den vorgegebenen Temperaturbereich hinweg ermittelt,

f) in einem dritten Kalibrierschritt wird ein Korrekturfaktor K so ermittelt, daß eine von dem ersten Kalibriersignal $M_1$, dem zweiten Kalibriersignal $M_2$ und dem Korrekturfaktor K abhängige Kalibrierfunktion $M_K = (2 \cdot M_1 \cdot M_2)/(M_1 + M_2 + K \cdot (M_1 - M_2))$ über den vorgegebenen Temperaturbereich im wesentlichen konstant ist;

g) in einem vierten Kalibrierschritt werden die Polarisatorwinkel $\theta$ und $\eta$ der beiden Polarisatoren (5,6) so eingestellt, daß das sich einstellende Meßsignal (M) bei wenigstens einem Temperaturwert aus dem vorgegebenen Temperaturbereich im wesentlichen gleich der Kalibrierfunktion $M_K$ ist.

3. Verfahren nach Anspruch 1 oder Anspruch 2, bei dem

a) die optische Reihenschaltung (1) von zwei Lichtsignalen (L1, L2) in zueinander entgegengesetzten Durchlaufrichtungen durchlaufen wird und

b) das Meßsignal (M) als Quotient zweier linearer Funktionen der Lichtintensitäten (I1, I2) der beiden Lichtsignale (L1,L2) jeweils nach deren Durchlaufen der optischen Reihenschaltung (1) oder als Effektivwert dieses Quotienten abgeleitet wird.

4. Verfahren nach Anspruch 1 oder 2, bei dem

   a) die optische Reihenschaltung (1) von zwei Lichtsignalen (L1, L2) in zueinander entgegengesetzten Durchlaufrichtungen durchlaufen wird und

   b) das Meßsignal (M) proportional zum Quotienten aus einer Differenz und der Summe der Lichtintensitäten (I1,I2) der beiden Lichtsignale (L1,L2) jeweils nach deren Durchlaufen der optischen Reihenschaltung (1) oder zu einem Effektivwert dieses Quotienten ist.

5. Verfahren nach Anspruch 1 oder Anspruch 2, bei dem

   a) die optische Reihenschaltung (1) von einem Lichtsignal (L) durchlaufen wird,

   b) ein Kalibriermagnetfeld ($H_0$) mit einem im wesentlichen konstanten Frequenzspektrum oberhalb einer vorgegebenen Frequenz verwendet wird und

   c) das Meßsignal (M) proportional zu dem Quotienten aus einem Wechselanteil ($I_{AC}$) der Lichtintensität (I) des Lichtsignals (L) nach Durchlaufen der Reihenschaltung (1) und einem Gleichanteil ($I_{DC}$) dieser Lichtintensität (I) ist, wobei der Wechselanteil ($I_{AC}$) im wesentlichen das Frequenzspektrum des Kalibriermagnetfeldes ($H_0$) enthält und der Gleichanteil ($I_{DC}$) keine Frequenzen aus dem Frequenzspektrum des Kalibriermagnetfeldes ($H_0$) aufweist.

6. Optische Meßanordnung zum Messen eines Magnetfeldes (H) mit einer optischen Reihenschaltung aus einer ersten optischen Übertragungsstrecke (4), einem ersten Polarisator (5), dessen Polarisationsachse (P1) einen ersten Polarisatorwinkel θ mit einer vorgegebenen Referenzachse (R) einschließt, einer Faraday-Sensoreinrichtung (3), einem zweiten Polarisator (6), dessen Polarisationsachse (P2) einen zweiten Polarisatorwinkel η mit der Referenzachse (R) einschließt und einer zweiten optischen Übertragungsstrecke (7), dadurch gekennzeichnet, daß die beiden Polarisatorwinkel θ und η gemäß dem vierten Kalibrierschritt nach Anspruch 1 oder 2 eingestellt sind.

7. Meßanordnung nach Anspruch 6, bei der die Faraday-Sensoreinrichtung (3) eine inhomogene lineare Doppelbrechung aufweist.

**Claims**

1. Method for the temperature calibration of an optical measurement arrangement that is intended for the measurement of a magnetic field and that has an optical series connection (1) comprising a first optical transmission path (4), a first polarizer (5) having a polarization axis (P1) that encloses a first polarizer angle θ with a specified reference axis (R), a Faraday sensor device (3), a second polarizer (6) having a polarization axis (P2) that encloses a second polarizer angle η with the reference axis (R), and a second optical transmission path (7), which method comprises the following method steps:

   a) the Faraday sensor device (3) is disposed in a calibrating magnetic field ($H_0$),

   b) at least one light signal (L, L1, L2) passes through the optical series circuit (1),

   c) a test signal (M) for the calibrating magnetic field ($H_0$) is determined from the light intensity (I, I1, I2) of the at least one light signal (L, L1, L2) after passing through the series connection (1),

   d) in a first calibration step, the first polarizer angle θ is set to a value $\theta_1$ and the second polarizer angle η to a value $\eta_1$ so that the condition

   $$\sin(2\theta_1 - 2\eta_1) = 1 \text{ or } \sin(2\theta_1 - 2\eta_1) = -1$$

   is essentially fulfilled and the resultant test signal is determined as first calibration signal $M_1$ over a specified temperature range comprising at least two temperature values,

   e) in a second calibration step, the first polarizer angle θ is set to a value $\theta_2$ and the second polarizer angle η

to a value $\eta_2$ so that the condition

$$\sin(2\theta_2 - 2\eta_2) = 1 \text{ or } \sin(2\theta_2 - 2\eta_2) = -1,$$

on the one hand, and at the same time

$$\cos(2\theta_2 + 2\eta_2) = -\cos(2\theta_1 + 2\eta_1),$$

on the other hand, are essentially fulfilled and the resultant test signal is determined as second calibration signal $M_2$ over the specified temperature range,
f) in a third calibration step, a correction factor K is determined in such a way that a calibration function $M_K = (2 \cdot M_1 \cdot M_2)/(M_1 + M_2 + K \cdot (M_1 - M_2))$ that is dependent on the first calibration signal $M_1$, the second calibration signal $M_2$ and the correction factor K is essentially constant over the specified temperature range,
g) in a fourth calibration step, the polarizer angles $\theta$ and $\eta$ of the two polarizers (5, 6) are set in such a way that the relationships

$$\sin(2\theta - 2\eta) = 1 \text{ or } \sin(2\theta - 2\eta) = -1,$$

on the one hand, and at the same time

$$\cos(2\theta + 2\eta) = K \cdot \cos(2\theta_1 + 2\eta_1)$$

on the other hand, are essentially fulfilled.

2. Method for the temperature calibration of an optical measurement arrangement that is intended for the measurement of a magnetic field and that has an optical series connection (1) comprising a first optical transmission path (4), a first polarizer (5) having a polarization axis (P1) that encloses a first polarizer angle $\theta$ with a specified reference axis (R), a Faraday sensor device (3), a second polarizer (6) having a polarization axis (P2) that encloses a second polarizer angle $\eta$ with the reference axis (R), and a second optical transmission path (7) which method comprises the following method steps:

a) the Faraday sensor device (3) is disposed in a calibrating magnetic field (**H₀**),
b) at least one light signal (L, L1, L2) passes through the optical series circuit (1),
c) a test signal (M) for the calibrating magnetic field (**H₀**) is determined from the light intensity (I, I1, I2) of the at least one light signal (L, L1, L2) after passing through the series connection (1),
d) in a first calibration step, the first polarizer angle $\theta$ is set to a value $\theta_1$ and the second polarizer angle $\eta$ to a value $\eta_1$ so that the condition

$$\sin(2\theta_1 - 2\eta_1) = 1 \text{ or } \sin(2\theta_1 - 2\eta_1) = -1$$

is essentially fulfilled and the resultant test signal is determined as first calibration signal $M_1$ over a specified temperature range comprising at least two temperature values,
e) in a second calibration step, the first polarizer angle $\theta$ is set to a value $\theta_2$ and the second polarizer angle $\eta$ to a value $\eta_2$ so that the conditions

$$\sin(2\theta_2 - 2\eta_2) = 1 \text{ or } \sin(2\theta_2 - 2\eta_2) = -1,$$

on the one hand, and at the same time

$$\cos(2\theta_2 + 2\eta_2) = -\cos(2\theta_1 + 2\eta_1),$$

on the other hand, are essentially fulfilled and the resultant test signal is determined as second calibration signal $M_2$ over the specified temperature range,

f) in a third calibration step, a correction factor K is determined in such a way that a calibration function $M_K = (2 \cdot M_1 \cdot M_2) / (M_1 + M_2 + K \cdot (M_1 - M_2))$ that is dependent on the first calibration signal $M_1$, the second calibration signal $M_2$ and the correction factor K is essentially constant over the specified temperature range,

g) in a fourth calibration step, the polarizer angles $\theta$ and $\eta$ of the two polarizers (5, 6) are set in such a way that the resultant test signal (M) is essentially equal to the calibration function $M_K$ at at least one temperature value in the specified temperature range.

3. Method according to Claim 1 or 2, in which

a) two light signals (L1, L2) pass through the optical series connection (1) in mutually opposite directions of travel and

b) the test signal (M) is derived as the quotient of two linear functions of the light intensities (I1, I2) of the two light signals (L1, L2) after each has passed through the optical series connection (1) or as the rms value of said quotient.

4. Method according to Claim 1 or 2, in which

a) two light signals (L1, L2) pass through the optical series connection (1) in mutually opposite directions of travel and

b) the test signal (M) is proportional to the quotient of a difference and of the sum of the light intensities (I1, I2) of the two light signals (L1, L2) after each has passed through the optical series connection (1) or to an rms value of said quotient.

5. Method according to Claim 1 or 2, in which

a) one light signal (L) passes through the optical series connection (1),

b) a calibrating magnetic field ($\mathbf{H_0}$) is used that has an essentially constant frequency spectrum above a specified frequency, and

c) the test signal (M) is proportional to the quotient of an alternating component ($I_{AC}$) of the light intensity (I) of the light signal (L) after passing through the series connection (1) and a DC component ($I_{DC}$) of said light intensity (I), wherein the alternating component ($I_{AC}$) essentially contains the frequency spectrum of the calibrating magnetic field ($\mathbf{H_0}$) and the DC component ($I_{DC}$) comprises no frequencies from the frequency spectrum of the calibrating magnetic field ($\mathbf{H_0}$).

6. Optical measurement arrangement for measuring a magnetic field ($\mathbf{H}$) having an optical series connection comprising a first optical transmission path (4), a first polarizer (5) whose polarization axis (P1) encloses a first polarizer angle $\theta$ with a specified reference axis (R), a Faraday sensor device (3), a second polarizer (6) whose polarization axis (P2) encloses a second polarizer angle $\eta$ with the reference axis (R), and a second optical transmission path (7), characterized in that the two polarizer angles $\theta$ and $\eta$ are set in accordance with the fourth calibration step according to Claim 1 or 2.

7. Measurement arrangement according to Claim 6, in which the Faraday sensor device (3) has a non-homogeneous linear birefringence.

**Revendications**

1. Procédé d'étalonnage en température d'un agencement optique de mesure qui est destiné à mesurer un champ magnétique et qui comprend un circuit optique série (1) constitué d'un premier parcours de transmission optique (4), d'un premier polariseur (5) présentant un axe de polarisation (P1) qui forme un premier angle de polariseur $\theta$ avec un axe de référence (R) prescrit, d'un système de capteur de Faraday (3), d'un second polariseur (6) présentant un axe de polarisation (P2) qui forme un second angle de polariseur $\eta$ avec l'axe de référence (R), et d'un second parcours de transmission optique (7), le procédé comprenant les étapes de procédé suivantes :

a) le système de capteur de Faraday (3) est disposé dans un champ magnétique d'étalonnage ($H_0$) ;

b) au moins un signal lumineux (L, L1, L2) passe dans le circuit optique série (1) ;

c) à partir de l'intensité lumineuse (I, I1, I2) dudit au moins un signal lumineux, on détermine, après passage du circuit série (1), un signal de mesure (M) pour le champ magnétique d'étalonnage ($H_0$),

d) dans une première étape d'étalonnage, on règle le premier angle de polariseur $\theta$ à une valeur $\theta_1$, et le second angle de polariseur $\eta$ à une valeur $\eta_1$ de manière à ce que soit sensiblement satisfaite la condition

$$\sin(2\theta_1 - 2\eta_1) = 1 \text{ ou } \sin(2\theta_1 - 2\eta_1) = -1$$

et l'on détermine le signal de mesure, qui s'établit, en tant que premier signal d'étalonnage $M_1$ en parcourant une plage de température prescrite comportant au moins deux valeurs de température,

e) dans une seconde étape d'étalonnage on règle le premier angle de polariseur $\theta$ à une valeur $\theta_2$, et le second angle de polariseur $\eta$ à une valeur $\eta_2$ de manière à ce que soient sensiblement satisfaites les conditions

$$\sin(2\theta_2 - 2\eta_2) = 1 \text{ ou } \sin(2\theta_2 - 2\eta_2) = -1$$

d'une part
et simultanément

$$\cos(2\theta_2 + 2\eta_2) = -\cos(2\theta_1 + 2\eta_1)$$

d'autre part,

et l'on détermine le signal de mesure, qui s'établit, en tant que second signal d'étalonnage $M_2$ en parcourant la plage de température prescrite,

f) dans une troisième étape d'étalonnage, on détermine un facteur de correction K de façon telle, qu'une fonction d'étalonnage dépendant du premier signal d'étalonnage $M_1$, du second signal d'étalonnage $M_2$ et du facteur de correction K, à savoir

$M_K = (2 \cdot M_1 \cdot M_2) / (M_1 + M_2 + K \cdot (M_1 - M_2)$ soit sensiblement constante sur toute la plage de température prescrite ;

g) dans une quatrième étape d'étalonnage, les angles de polariseur $\theta$ et $\eta$ des deux polariseurs (5, 6) sont réglés de façon à ce que soient vérifiées sensiblement les relations

$$\sin(2\theta - 2\eta) = 1 \text{ ou } \sin(2\theta - 2\eta) = -1$$

d'une part
et simultanément

$$\cos(2\theta + 2\eta) = K \cdot \cos(2\theta_1 + 2\eta_1)$$

d'autre part.

2. Procédé d'étalonnage en température d'un agencement optique de mesure qui est destiné à mesurer un champ magnétique et qui comprend un circuit optique série (1) constitué d'un premier parcours de transmission optique (4), d'un premier polariseur (5) présentant un axe de polarisation (P1) qui forme un premier angle de polariseur $\theta$ avec un axe de référence (R) prescrit, d'un système de capteur de Faraday (3), d'un second polariseur (6) présentant un axe de polarisation (P2) qui forme un second angle de polariseur $\eta$ avec l'axe de référence (R), et d'un second parcours de transmission optique (7), le procédé comprenant les étapes de procédé suivantes :

a) le système de capteur de Faraday (3) est disposé dans un champ magnétique d'étalonnage ($H_0$) ;

b) au moins un signal lumineux (L, L1, L2) passe dans le circuit optique série (1) ;

c) à partir de l'intensité lumineuse (I, I1, I2) dudit au moins un signal lumineux, on détermine, après passage du circuit série (1), un signal de mesure (M) pour le champ magnétique d'étalonnage ($H_0$),

d) dans une première étape d'étalonnage, on règle le premier angle de polariseur $\theta$ à une valeur $\theta_1$, et le second angle de polariseur $\eta$ à une valeur $\eta_1$ de manière à ce que soit sensiblement remplie la condition

$$\sin(2\theta_1 - 2\eta_1) = 1 \text{ ou } \mathrm{Sin}(2\theta_1 - 2\eta_1) = -1$$

et l'on détermine le signal de mesure, qui s'établit, en tant que premier signal d'étalonnage $M_1$ en parcourant une plage de température prescrite et comportant au moins deux valeurs de température,

e) dans une seconde étape d'étalonnage on règle le premier angle de polariseur $\theta$ à une valeur $\theta_2$, et le second angle de polariseur $\eta$ à une valeur $\eta_2$ de manière à ce que soit sensiblement remplies les conditions

$$\sin(2\theta_2 - 2\eta_2) = 1 \text{ ou } \sin(2\theta_2 - 2\eta_2) = -1$$

d'une part
et simultanément

$$\cos(2\theta_2 + 2\eta_2) = -\cos(2\theta_1 + 2\eta_1)$$

d'autre part,

et l'on détermine le signal de mesure, qui s'établit, en tant que second signal d'étalonnage $M_2$ en parcourant la plage de température prescrite,

f) dans une troisième étape d'étalonnage, on détermine un facteur de correction K de façon telle, qu'une fonction d'étalonnage dépendant du premier signal d'étalonnage $M_1$, du second signal d'étalonnage $M_2$ et du facteur de correction K, à savoir

$M_K = (2 \cdot M_1 \cdot M_2) / (M_1 + M_2 + K(M_1 - M_2))$ soit sensiblement constante sur toute la plage de température prescrite ;

g) dans une quatrième étape d'étalonnage, les angles de polariseur $\theta$ et $\eta$ des deux polariseurs (5, 6) sont réglés de façon telle, que le signal de mesure (M) qui s'établit, pour au moins une valeur de température de la plage de température prescrite, soit sensiblement identique à la fonction d'étalonnage $M_K$.

**3.** Procédé selon la revendication 1 ou la revendication 2, pour lequel

a) le circuit optique série (1) est parcouru par deux signaux lumineux (L1, L2) dans des sens de passage opposés, et

b) le signal de mesure (M) est déduit en tant que quotient de deux fonctions linéaires des intensités lumineuses (I1, I2) des deux signaux lumineux (L1, L2) après leur passage respectif dans le circuit optique série (1), ou en tant que valeur efficace de ce quotient.

**4.** Procédé selon la revendication 1 ou 2, pour lequel

a) le circuit optique série (1) est parcouru par deux signaux lumineux (L1, L2) dans des sens de passage opposés, et

b) le signal de mesure (M) est proportionnel au quotient d'une différence et de la somme des intensités lumineuses (I1, I2) des deux signaux lumineux (L1, L2) après leur passage respectif dans le circuit optique série (1), ou à une valeur efficace de ce quotient.

**5.** Procédé selon la revendication 1 ou la revendication 2, pour lequel

a) le circuit optique série (1) est parcouru par un signal lumineux (L),

b) on utilise un champ magnétique d'étalonnage ($H_0$) présentant un spectre de fréquences sensiblement constant au-dessus d'une fréquence prescrite, et

c) le signal de mesure (M) est proportionnel au quotient d'une part alternative ($I_{AC}$) de l'intensité lumineuse (I) du signal lumineux (L) après passage du circuit série (1), et d'une part continue ($I_{DC}$) de cette intensité lumineuse (I), la part alternative ($I_{AC}$) englobant sensiblement le spectre de fréquences du champ magnétique d'étalonnage ($H_0$), et la part continue ($I_{DC}$) ne présentant pas de fréquences du spectre de fréquences du champ magnétique d'étalonnage ($H_0$).

**6.** Agencement optique de mesure destiné à mesurer un champ magnétique (H), comprenant comprend un circuit optique série constitué d'un premier parcours de transmission optique (4), d'un premier polariseur (5) présentant un axe de polarisation (P1) qui forme un premier angle de polariseur θ avec un axe de référence (R) prescrit, d'un système de capteur de Faraday (3), d'un second polariseur (6) présentant un axe de polarisation (P2) qui forme un second angle de polariseur η avec l'axe de référence (R), et d'un second parcours de transmission optique (7), **caractérisé** en ce que les deux angles de polariseur θ et η sont réglés conformément à la quatrième étape d'étalonnage selon la revendication 1 ou 2.

7. Agencement de mesure selon la revendication 6, dans lequel le système de capteur de Faraday (3) présente une biréfringence linéaire non homogène.

FIG 1

FIG 2

FIG 3

R

P2 (6)

$\eta_1$

$\theta_1 - \eta_1 = 45°$

P1 (5)

$\theta_1$

FIG 4

R

$\theta_2$

$\eta_2$

P1 (5)

$\theta_2 - \eta_2 = -45°$

P2 (6)

FIG 5

FIG 6